# FASCICULE DE BREVET EUROPEEN

(11) **EP 3 207 564 B1**
(45) Date de publication et mention de la délivrance du brevet: **18.08.2021**
(21) Numéro de dépôt: 15780848.6
(22) Date de dépôt: 14.10.2015
(51) Int. Cl.: H01L 21/58, H01L 23/00, H01L 21/18

(54) **PROCÉDÉ DE COLLAGE DIRECT VIA DES COUCHES MÉTALLIQUES PEU RUGUEUSES**
VERFAHREN ZUR DIREKTHAFTUNG ÜBER METALLSCHICHTEN MIT GERINGER RAUHEIT
METHOD FOR DIRECT ADHESION VIA LOW-ROUGHNESS METAL LAYERS

(30) Priorité: 17.10.2014 FR 1460017
(43) Date de publication de la demande: 23.08.2017
(73) Titulaire: Commissariat à l'Énergie Atomique et aux Énergies Alternatives, 75015 Paris (FR)
(72) Inventeur: GONDCHARTON, Paul, F-38100 Grenoble (FR); BENAISSA, Lamine, F-91300 Massy (FR); IMBERT, Bruno, F-38000 Grenoble (FR)
(74) Mandataire: Brevalex
(86) Numéro de dépôt international: PCT/EP2015/073746
(87) Numéro de publication internationale: WO 2016/059094

(56) Documents cités:
- FR-A1- 2 947 481
- EIJI HIGURASHI ET AL: "Low-Temperature Bonding of GaN on Si Using a Nonalloyed Metal Ohmic Contact Layer for GaN-Based Heterogeneous Devices", IEEE JOURNAL OF QUANTUM ELECTRONICS, IEEE SERVICE CENTER, PISCATAWAY, NJ, USA, vol. 48, no. 2, 1 février 2012 (2012-02-01), pages 182-186, XP011398510, ISSN: 0018-9197, DOI: 10.1109/JQE.2011.2170211
- OKADA H ET AL: "Room temperature vacuum sealing using surfaced activated bonding with au thin films", TRANSDUCERS '05 : THE 13TH INTERNATIONAL CONFERENCE ON SOLID-STATE SENSORS, ACTUATORS AND MICROSYSTEMS ; SEOUL, KOREA, [JUNE 5 - 9, 2005] ; DIGEST OF TECHNICAL PAPERS, IEEE OPERATIONS CENTER, PISCATAWAY, NJ, vol. 1, 5 juin 2005 (2005-06-05), pages 932-935, XP010828071, DOI: 10.1109/SENSOR.2005.1496571 ISBN: 978-0-7803-8994-6
- MARIAM SADAKA ET AL: "Building blocks for wafer-level 3D integration", INTERNET CITATION, 1 octobre 2009 (2009-10-01), page 6pp, XP007911313, ISSN: 0038-111X Extrait de l'Internet: URL:http://www.electroiq.com/index/display /semiconductors-article-display/5243540368 /articles/solid-state-technology/volume-52 /Issue_10/Features/Advanced_Packaging/Buil ding_blocks_for_wafer-level_3D_integration .html [extrait le 2010-01-27]
- STOGNIJ A I ET AL: "Preparation of ultrathin gold films by oxygen-ion sputtering and their optical properties", TECHNICAL PHYSICS, NAUKA/INTERPERIODICA, MO, vol. 48, no. 6, 1 juin 2003 (2003-06-01), pages 745-748, XP019314296, ISSN: 1090-6525

## Description

### DOMAINE TECHNIQUE

Le domaine de l'invention est celui de l'assemblage de deux substrats par collage direct de couches métalliques, en particulier pour application à la réalisation de dispositifs microélectroniques.

### ÉTAT DE LA TECHNIQUE ANTÉRIEURE

L'intégration en trois dimensions des dispositifs microélectroniques est une alternative intéressante pour en augmenter les performances, aujourd'hui limitées par leur intégration en deux dimensions. Cette technique consiste à empiler dans la troisième dimension des niveaux de composants actifs et à les relier à l'aide de la technologie TSV (*Through Silicon Vias*) qui permet de réaliser des vias de connexion à travers l'empilement. Le collage des différents niveaux de l'empilement est une étape-clé de cette technique.

Dans d'autres domaines de la microélectronique, le collage métallique est également utilisé pour permettre de limiter le budget thermique appliqué aux composants, par exemple dans la fabrication de composants de puissance, photoniques, photovoltaïques, etc.

Dans toutes ces applications, l'assemblage de substrats de silicium par la mise en contact direct de couches minces métalliques (notamment des couches de cuivre, ce matériau étant majoritairement utilisé dans les interconnexions en microélectronique) est essentiel à maîtriser dès les basses températures. En effet, l'utilisation de budgets thermiques peut perturber l'alignement ou détériorer les dispositifs actifs au sein des substrats. Pour toutes ces raisons, on cherche à obtenir un collage à forte tenue mécanique dès les basses températures.

Une autre thématique concerne la réalisation d'hétérostructures par collage de substrats présentant des coefficients de dilation thermique différents. Pour de nombreuses applications en effet, par exemple les composants solaires ou les composants radiofréquence, l'introduction de substrats de matériaux autres que le silicium est nécessaire (InP, GaAs, LiNbO₃, LiTaOs, quartz,...). Or les techniques actuelles de collage direct nécessite la maîtrise des états de surface avant collage et l'apport d'un budget thermique pour renforcer le collage et ainsi permettre la tenue mécanique de tels assemblages à des procédés post-collage (tel que l'amincissement mécanique ou le Smart Cut™). Avec l'ajout d'un budget thermique, les matériaux se dilatent différemment les uns des autres (du fait de la différence entre les coefficients de dilatation thermique des différents matériaux) ce qui engendre des contraintes bi-axiales dans l'empilement pouvant conduire à la fissuration, voire au clivage de l'un des substrats de l'assemblage. On cherche donc à assurer un collage le plus robuste possible aux températures d'assemblage et d'utilisation ultérieure, soit des températures typiquement comprises entre 20 et 50°C.

Différentes voies de réalisation permettent l'assemblage de substrats via le collage direct de couches minces métalliques. On précise ici que l'on entend par collage direct l'assemblage de substrats recouverts de couches minces métalliques sans utilisation de matériaux intermédiaires de type « colle polymère ».

Une première technique consiste à apporter de l'énergie au moment de la mise en contact des plaques par chauffage et application d'une pression uniaxiale de part et d'autre de l'assemblage. Cependant, cette technique nécessite des températures en général supérieures à 250°C et des pressions de l'ordre du Mégapascal pour obtenir des collages cuivre-cuivre à forte tenue mécanique. Cependant, par l'usage de cette technique, on perd l'avantage des basses températures de collage puisque l'on dépasse 50°C (limite supérieure de température de procédé imposée par certaines hétérostructures). Les paramètres de procédé utilisés dépendent également des métaux à assembler : les métaux réfractaires doivent ainsi être collés à de plus hautes températures et pressions que les métaux de transition (du fait de la différence de propriétés mécaniques des aspérités composant leur surface et de leur capacité à se déformer plastiquement).

Une autre technique permet de réaliser le collage à pression atmosphérique. Elle met en œuvre une activation par bombardement ionique des surfaces des couches métalliques réalisée sous vide et l'assemblage des substrats à pression atmosphérique par mise en contact direct de couches d'adsorbat formées sur les couches métalliques et dont l'épaisseur est limitée par exposition à du dioxygène gazeux à l'humidité contrôlée. Outre l'environnement en vide, cette technique présente l'inconvénient de nécessiter de réaliser le collage à une température de 150°C, incompatible avec certaines applications envisagées, notamment la réalisation de certaines hétérostructures. On pourra par exemple se reporter à l'article de Shigetou, A. et Suga, T., « Modified diffusion bond process for chemical mechanical polishing (CMP)-Cu at 150C in ambient air », in Electron. Compon. Technol. Conf. 2009 ECTC 2009 59th 365-369 (2009).

Une autre technique permet de réaliser le collage à température ambiante. Elle consiste à la mise en contact direct de surfaces métalliques sous ultra vide immédiatement après leur dépôt sans remise à l'air entre le dépôt et le collage. Cette technique permet l'assemblage de substrats dès la température ambiante sous compression mais nécessite un environnement de collage en ultravide difficilement utilisable en industrie (temps de procédé long en désorption, utilisation de pompes tertiaires à piège de titane, manipulation des substrats dans le bâti sous ultra-vide). On pourra par exemple se reporter à l'article de Shimatsu, T. et Uomoto, M. « Atomic diffusion bonding of wafers with thin nanocrystalline metal films », J. Vac. Sci. Technol. B Microelectron. Nanometer Struct. 28, 706 -714 (2010).

Enfin une dernière technique décrite dans le brevet FR 2947481 B1 nécessite l'activation des surfaces par polissage mécano-chimique (CMP) et nettoyage. Cette étape permet notamment d'obtenir des surfaces peu rugueuses (rugosité RMS inférieures à 1 nm) et hydrophiles (entre 0 et 20° d'angle de goutte à l'eau). Le collage peut ainsi s'effectuer à température ambiante, sous pression atmosphérique notamment à l'air et sans pression uniaxiale au moment de la mise en contact des plaques. Cette technique nécessite cependant une technique de CMP maîtrisée dépendante des métaux à coller. De plus, selon la nature de l'oxyde métallique formé lors du polissage et du nettoyage (appelé couche cristalline enrichie en oxygène dans le brevet), la tenue mécanique de l'assemblage final à température ambiante peut ne pas être suffisante pour supporter les procédés post-collage. Dans ce cas, la réalisation d'un recuit est nécessaire, et les 50°C de limite supérieure pour certaines applications sont alors dépassés.

On comprend donc que ces différentes techniques présentent des inconvénients auxquels il serait souhaitable de remédier : atmosphère de collage sous ultra-vide contraignante, budgets thermiques nécessaires au renforcement de l'énergie de collage et non compatible avec la réalisation d'hétérostructures, pression appliquée au moment de la mise en contact des plaques, procédés de polissage sensibles au matériau.

### EXPOSÉ DE L'INVENTION

L'invention vise à répondre à cet objectif et propose pour cela un procédé d'assemblage d'un premier substrat et d'un deuxième substrat par l'intermédiaire de couches de collage métalliques, comprenant les étapes de :
- dépôt, en surface de chacun des premier et deuxième substrats, d'une couche métallique d'épaisseur contrôlée pour borner la rugosité de surface de chacune des couches métalliques déposées en dessous d'un seuil de rugosité fonction du métal composant les couches métalliques ;
- mise à l'air des couches métalliques déposées en surface des premier et deuxième substrats ;
- collage direct des premier et deuxième substrats par mise en contact des couches de collage métalliques, la rugosité de surface des couches mises en contact étant celle issue de l'étape de dépôt.

Certains aspects préférés mais non limitatifs de procédé sont les suivants :
- l'étape de collage est mise en œuvre après un temps maximal d'exposition à l'air des couches métalliques déposées suite ladite mise à l'air inférieur à 30 minutes, de préférence inférieur à 20 minutes ;
- l'étape de collage est réalisée à une température inférieure à 50°C, de préférence à température ambiante, par exemple entre 10° et 30°C ;
- l'étape de collage est réalisée à pression atmosphérique ;
- l'étape de collage est réalisée à l'air ;
- l'étape de collage est réalisée sans application de pression à l'assemblage des premier et deuxième substrats résultant de la mise en contact direct des couches de collage métalliques ;
- il comprend, avant le dépôt d'une couche métallique en surface du premier substrat, une étape de formation sur ledit premier substrat d'une couche superficielle ;
- la couche superficielle est une couche formant barrière à la diffusion du matériau de la couche métallique dans le premier substrat, par exemple une couche superficielle de nitrure de titane ou de nitrure de tantale ;
- la couche superficielle est une couche en un matériau choisi parmi les diélectriques, les nitrures ou les métaux dont la rugosité de surface ne permet pas le collage direct des premier et deuxième substrats ;
- les premier et deuxième substrats présentent des coefficients de dilatation thermique différents ;
- les couches métalliques sont déposées par voie physique en phase vapeur ;
- les couches métalliques sont des couches de cuivre d'épaisseur contrôlée pour borner leur rugosité de surface, telle que mesurée avec un microscope à force atomique balayant une surface de 1*1 µm², en dessous de 1,0 nm RMS ;
- les couches métalliques sont des couches d'or d'épaisseur contrôlée pour borner leur rugosité de surface, telle que mesurée avec un microscope à force atomique balayant une surface de 1*1 µm², en dessous de 1,2 nm RMS ;
- il comprend, avant le collage, la formation, par implantation d'espèces atomiques, d'une zone de fragilisation à l'intérieur du premier substrat, et, après collage, le retrait d'une portion du premier substrat par séparation dudit premier substrat au niveau de la zone de fragilisation.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- les figures la-lc sont des schémas illustrant les étapes d'un mode de réalisation possible du procédé selon l'invention ;
- les figures 2a et 2b illustrent la rugosité de surface de couches métalliques, respectivement d'or et de cuivre, en fonction de l'épaisseur déposée sur un substrat de silicium recouvert d'une couche superficielle de nitrure de titane ;
- les figures 3a et 3b illustrent un collage de substrats de silicium par contact direct de couches superficielles de molybdène et par contact direct de couches métalliques d'or déposées sur de telles couches de molybdène ;
- la figure 4 illustre les phénomènes de collage lors et après mise en contact direct des couches métalliques d'or de la figure 3b.

### EXPOSÉ DÉTAILLÉ DE MODES DE RÉALISATION PARTICULIERS

En référence aux figures la à 1c, l'invention porte sur un procédé d'assemblage d'un premier substrat 1 et d'un deuxième substrat 3 par l'intermédiaire de couches de collage métalliques 2, 4. Les substrats 1, 3 sont constitués de matériaux choisis d'une manière générale parmi les matériaux semi-conducteurs, métalliques ou céramiques utilisés dans l'industrie microélectronique. Les substrats ne sont pas nécessairement de nature identique, et peuvent notamment présenter des coefficients de dilation thermique différents au moins dans l'une des orientations des substrats, typiquement des coefficients différant d'au moins 10% ou 20% à température ambiante. A titre d'exemples illustratifs, le premier substrat peut être un substrat de silicium et le deuxième substrat peut être un substrat de quartz ou de niobate de lithium.

Comme illustré sur la figure la, le procédé comprend une étape de dépôt, en surface de chacun des premier et deuxième substrats 1, 3, d'une couche métallique 2, 4, par exemple par voie physique en phase vapeur PVD (pour *Physical Vapor Deposition*).

La couche métallique 2, 4 déposée en surface de chacun des substrats 1, 3 est par exemple une couche d'aluminium, d'or, d'argent, de titane ou de cuivre.

Dans un mode de réalisation possible, le procédé comprend, avant le dépôt d'une couche métallique en surface de l'un des substrats, par exemple le premier substrat, une étape de formation sur ledit substrat d'une couche superficielle. La couche superficielle est par exemple une couche de métal ou une couche d'oxyde. La couche superficielle peut notamment être une couche formant barrière à la diffusion du matériau de la couche métallique dans le substrat, par exemple une couche superficielle de nitrure de titane ou de nitrure de tantale. La couche superficielle peut également être une couche en un matériau choisi parmi les diélectriques, les nitrures ou les métaux dont la rugosité de surface ne permet pas le collage direct des premier et deuxième substrats.

Dans le cadre de l'invention, les couches métalliques déposées 2, 4 sont chacune d'épaisseur contrôlée pour borner la rugosité de surface de chacune des couches métalliques déposées en dessous d'un seuil de rugosité.

Il est connu que plus l'épaisseur d'une couche métallique déposée est élevée, plus la rugosité de surface de la couche métallique augmente. Ainsi, selon la rugosité de surface des premier et deuxième substrats 1, 3, l'homme du métier sait parfaitement adapter l'épaisseur de métal déposée afin que la rugosité de surface des couches métalliques déposées reste en dessous du seuil de rugosité. Cette contrainte se traduit pratiquement par le dépôt de couches métalliques 2, 4 très minces, par exemple d'épaisseurs inférieures à 100 nm.

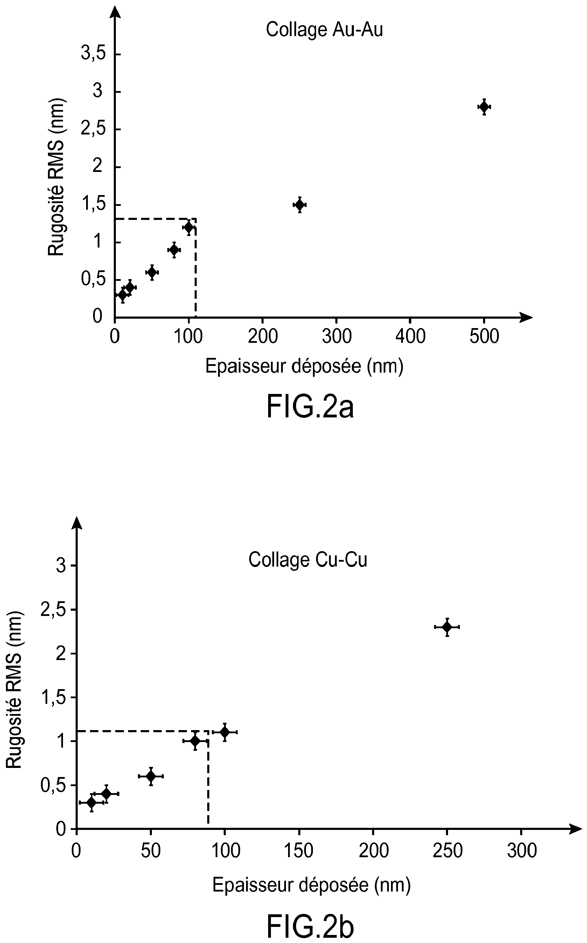

On a représenté sur les figures 2a et 2b l'évolution de la rugosité de surface, telle que mesurée avec un microscope à force atomique balayant une surface de 1*1 µm², de couches métalliques respectivement d'or et de cuivre en fonction de l'épaisseur déposée sur un substrat de silicium recouvert d'une couche superficielle de nitrure de titane de 20nm d'épaisseur. Sur chacune de ces figures, la zone entourée de pointillés représentent les couples de paramètres compatibles avec le collage direct selon l'invention.

Ainsi, lorsque les couches métalliques sont des couches de cuivre, on vient de préférence contrôler leur épaisseur pour borner leur rugosité de surface, telle que mesurée avec un microscope à force atomique balayant une surface de 1*1 µm², en dessous de 1,0 nm RMS. Cela correspond, pour une couche métallique continue (pleine plaque), à une rugosité de surface de crête à creux en dessous d'environ 10 nm.

De manière similaire, lorsque les couches métalliques sont des couches d'or, on vient de préférence contrôler leur épaisseur pour borner leur rugosité de surface, telle que mesurée avec un microscope à balayage atomique balayant une surface de 1*1 µm², en dessous de 1,2 nm RMS. Cela correspond, pour une couche métallique continue (pleine plaque), à rugosité de surface de crête à creux en dessous d'environ 12 nm.

Revenant à la description du procédé selon l'invention, celui-ci comporte suite à la formation des couches métalliques une étape de mise à l'air des couches métalliques déposées 2, 4 en surface des premier et deuxième substrats 1, 3. Cette mise à l'air rend le procédé selon l'invention beaucoup plus aisé à mettre en place d'un point de vue industriel que les techniques nécessitant d'assurer un environnement de vide ou d'atmosphère protectrice contre l'oxydation métallique. Cette mise à l'air est réalisée directement après la formation des couches métalliques, c'est-à-dire sans réalisation d'étape technologique intermédiaire qui viendrait modifier les caractéristiques physico-chimique de surface des couches métalliques, notamment leur rugosité.

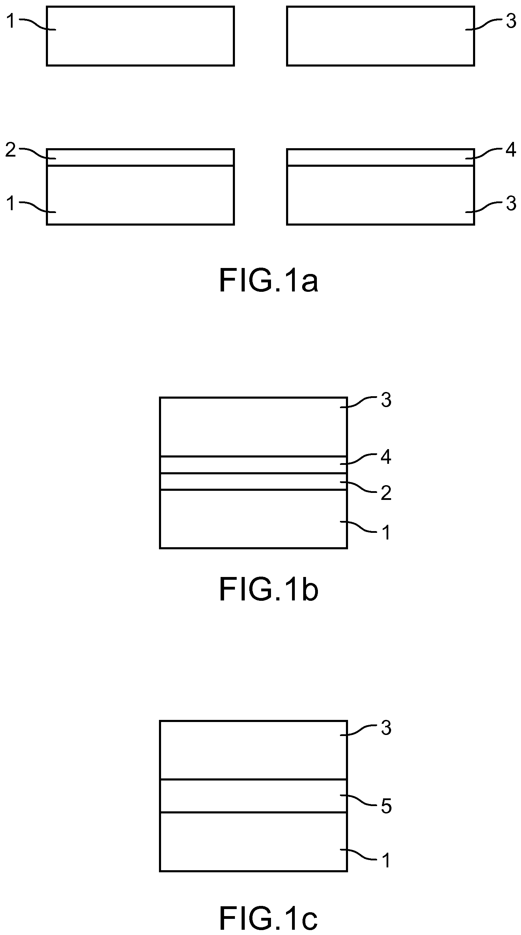

Puis en référence à la figure 1b, le procédé comporte une étape de collage des premier et deuxième substrats 1, 3 par mise en contact direct des couches de collage métalliques 2, 4 déposées à rugosité de surface bornée par l'étape de dépôt. La rugosité de surface des couches mises en contact direct est ainsi directement issue de l'étape de dépôt, sans qu'un polissage de type CMP ou autre opération venant modifier la rugosité de surface ne soit nécessaire. Ainsi le procédé ne comprend pas d'étape venant modifier la rugosité de surface après la formation des couches métalliques, telle qu'une étape de polissage CMP, pour obtenir le collage, la rugosité de surface des couches mises en contact direct étant celle obtenue à l'issue de l'étape de dépôt.

Dans le cadre de la présente description, les termes de collage direct et de collage par mise en contact direct sont équivalents.

Cette étape de collage est mise en œuvre après un temps maximal d'exposition à l'air des couches métalliques déposées suite ladite mise à l'air qui est de préférence inférieur à 30 minutes, encore plus de préférence inférieur à 20 minutes. Elle est mise en œuvre directement après l'étape de mise à l'air, c'est-à-dire sans réalisation d'étape technologique intermédiaire qui viendrait modifier les caractéristiques physico-chimique de surface des couches métalliques, notamment leur rugosité.

L'étape de collage peut notamment être réalisée à une température inférieure à 50°C, en particulier à température ambiante, par exemple entre 10°C et 30°C. Elle peut en outre être réalisée à pression atmosphérique, notamment à l'air. Elle peut également être réalisée sans application de pression à l'assemblage des premier et deuxième substrats résultant de la mise en contact des couches de collage métalliques, l'adhésion résultant du simple rapprochement des substrats.

A l'issue de l'étape de collage, et comme schématiquement représenté sur la figure 1c, on n'observe aucune interface de collage entre les couches métalliques 2, 4 mais *in fine* une unique couche métallique 5 entre les premier et deuxième substrats 1, 3. Le collage se traduit ainsi par une reconstruction de l'interface de collage (c'est-à-dire une interpénétration de grains à travers l'interface de collage), aucune couche continue d'oxyde métallique n'étant détectée à l'interface.

Sans vouloir s'attacher à une quelconque théorie scientifique, l'hypothèse suivante du mécanisme permettant de réaliser un tel collage peut être avancée :
- Le fait d'enchaîner le dépôt de la couche mince métallique, la remise à l'air et la mise en contact des surfaces empêche ou limite la formation d'une couche d'oxyde métallique ou d'une couche d'hydrocarbures adsorbées en surface, ce qui laisse la possibilité de création de liaisons métalliques à température ambiante. Cette hypothèse est notamment étayée par des mesures de travaux d'adhésion élevés indiquant un changement dans le régime d'adhésion. Les forces attractives mises en jeu sont donc ainsi plus fortes que dans le cas classique dans lequel les forces de van der Waals sont motrices de l'adhésion.
- La nature des deux métaux utilisés dans le procédé de l'invention est particulière : ce sont des matériaux ductiles. Ainsi, dans le mécanisme d'adhésion, les forces répulsives étant liées à la réponse mécanique des aspérités, ces matériaux vont avoir une tendance à mieux se déformer sous l'action des forces attractives. L'action combinée de cette déformation plus aisée et des forces mises en jeu plus fortes conduit donc à repousser la limite de rugosité compatible avec le collage direct de ces surfaces.

Outre de permettre la réalisation d'un collage ne nécessitant pas d'atmosphère sous ultra-vide, pas d'application pas de budget thermique, pas d'application de pression, pas de polissage, un autre intérêt de l'invention concerne l'assemblage de couches superficielles qui présentent une rugosité trop élevée pour permettre leur collage direct.

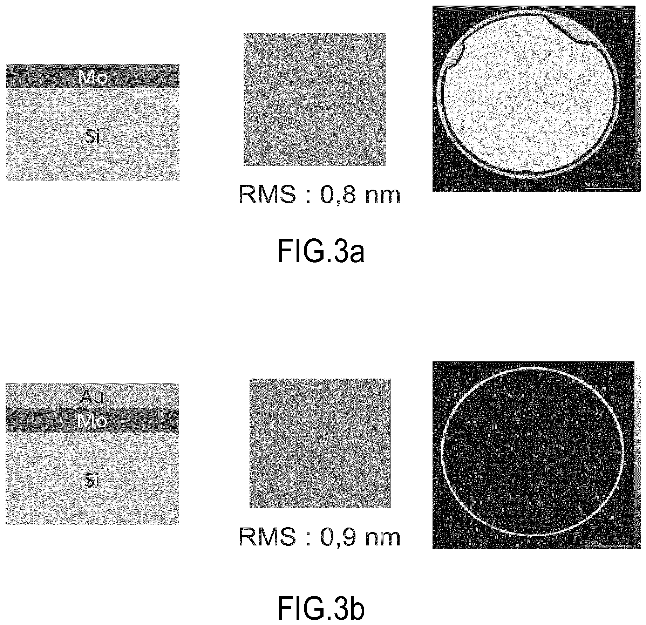

A titre d'exemple, on considère des couches superficielles de molybdène déposées sur des substrats de Si et dont la rugosité de surface de 0,8nm RMS est trop élevée pour permettre leur assemblage par mise en contact direct comme cela ressort de la figure 3a. La qualité du collage est évaluée par microscopie acoustique à balayage : les zones au contraste le plus clair ne sont pas collées alors que les zones au contraste le plus sombre le sont. En revanche, en venant déposer une fine couche d'or d'épaisseur de 10 nm sur une couche de molybdène, on assure une rugosité de surface de 0,9 nm RMS inférieur au seuil de rugosité de 1,2nm RMS exemplifié ci-dessus, et ainsi la réalisation d'un collage direct aboutissant à un assemblage parfait comme cela ressort de la figure 3b.

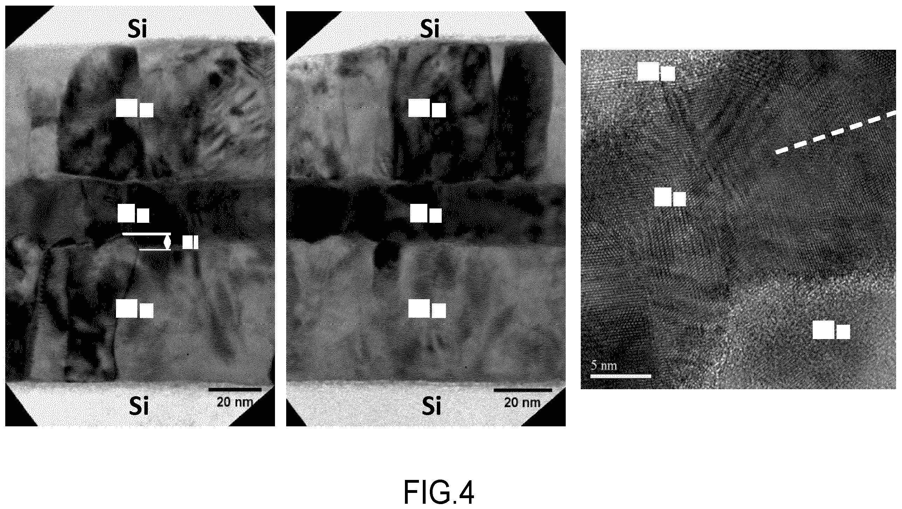

Afin d'étudier les phénomènes après collage direct de la structure de la figure 3b, des coupes TEM (pour *Transmission Electron Microscopy*) ont été réalisées et observées sur le collage de la structure Si-Mo-Au| |Au-Mo-Si. La coupe de gauche de la figure 4 illustre la structure immédiatement après mise en contact, la référence RI indiquant la rugosité initiale de la couche de molybdène. La coupe centrale et celle de droite (où la ligne pointillée est positionnée au niveau de l'interface originelle) de la figure 4 illustrent la reconstruction complète des couches d'or et la disparition de l'interface de collage à température ambiante. Les surfaces d'or ne possédant ni oxydes ni hydrocarbures ont effectué un réel « zip atomique » des deux surfaces. Enfin, la ductilité des couches d'or a permis de coller des surfaces de Mo montrant des rugosités très importantes en tête de grains (notamment dû à la croissance du Mo typée colonnaire).

Dans un mode de réalisation possible de l'invention, le procédé comprend suite au collage une étape de retrait d'une portion du premier substrat. Ce retrait peut être réalisé par amincissement mécanique et/ou chimique, ou encore par séparation du premier substrat au niveau d'une zone préalablement fragilisée, par exemple par mise en œuvre d'une implantation ionique. Ainsi le procédé selon l'invention peut comprendre, avant le collage des substrats, la formation par implantation d'espèces atomiques d'une zone de fragilisation à l'intérieur du premier substrat, et l'amincissement, après le collage, du premier substrat par séparation dudit premier substrat au niveau de la zone de fragilisation. En mettant ainsi en œuvre la technologie Smart Cut™ dans le cadre du procédé selon l'invention, on peut réaliser le report d'une couche sur un autre substrat, en particulier malgré des coefficients de dilation thermique différents.

## Revendications

1. Procédé d'assemblage d'un premier substrat (1) et d'un deuxième substrat (3) par l'intermédiaire de couches de collage métalliques (2, 4), comprenant les étapes de :
- dépôt, en surface de chacun des premier et deuxième substrats (1, 3), d'une couche métallique (2, 4) d'épaisseur contrôlée pour borner la rugosité de surface de chacune des couches métalliques déposées en dessous d'un seuil de rugosité fonction du métal composant les couches métalliques ;
- mise à l'air des couches métalliques déposées en surface des premier et deuxième substrats ;
- collage direct des premier et deuxième substrats par mise en contact des couches de collage métalliques déposées, la rugosité de surface des couches mises en contact étant celle obtenue à l'issue de l'étape de dépôt.

2. Procédé selon la revendication 1, dans lequel l'étape de collage est mise en œuvre après un temps maximal d'exposition à l'air des couches métalliques déposées suite ladite mise à l'air inférieur à 30 minutes, de préférence inférieur à 20 minutes.

3. Procédé selon l'une des revendications 1 et 2, dans lequel l'étape de collage est réalisée à une température inférieure à 50°C, de préférence à température ambiante, par exemple entre 10° et 30°C.

4. Procédé selon l'une des revendications 1 à 3, dans lequel l'étape de collage est réalisée à pression atmosphérique.

5. Procédé selon l'une des revendications 1 à 4, dans lequel l'étape de collage est réalisée à l'air.

6. Procédé selon l'une des revendications 1 à 5, dans lequel l'étape de collage est réalisée sans application de pression à l'assemblage des premier et deuxième substrats résultant de la mise en contact des couches de collage métalliques.

7. Procédé selon l'une des revendications 1 à 6, comprenant, avant le dépôt d'une couche métallique en surface du premier substrat, une étape de formation sur ledit premier substrat d'une couche superficielle.

8. Procédé selon la revendication 7, dans lequel la couche superficielle est une couche formant barrière à la diffusion du matériau de la couche métallique dans le premier substrat, par exemple une couche superficielle de nitrure de titane ou de nitrure de tantale.

9. Procédé selon la revendication 7, dans lequel la couche superficielle est une couche en un matériau choisi parmi les diélectriques, les nitrures ou les métaux dont la rugosité de surface ne permet pas le collage direct des premier et deuxième substrats.

10. Procédé selon l'une des revendications 1 à 9, dans lequel les premier et deuxième substrats présentent des coefficients de dilatation thermique différents.

11. Procédé selon l'une des revendications 1 à 10, dans lequel les couches métalliques sont déposées par voie physique en phase vapeur.

12. Procédé selon l'une des revendications 1 à 11, dans lequel les couches métalliques sont des couches de cuivre d'épaisseur contrôlée pour borner leur rugosité de surface, telle que mesurée avec un microscope à force atomique balayant une surface de 1*1 µm², en dessous de 1,0 nm RMS.

13. Procédé selon l'une des revendications 1 à 11, dans lequel les couches métalliques sont des couches d'or d'épaisseur contrôlée pour borner leur rugosité de surface, telle que mesurée avec un microscope à force atomique balayant une surface de 1*1 µm², en dessous de 1,2 nm RMS.

14. Procédé selon l'une des revendications 1 à 13, comprenant, avant le collage, la formation, par implantation d'espèces atomiques, d'une zone de fragilisation à l'intérieur du premier substrat, et, après collage, le retrait d'une portion du premier substrat par séparation dudit premier substrat au niveau de la zone de fragilisation.

## Patentansprüche

1. Verfahren zum Zusammenfügen eines ersten Substrats (1) und eines zweiten Substrats (3) mittels metallischer Haftschichten (2, 4), umfassend die folgenden Schritte:
- Aufbringen, auf der Oberfläche von jedem von dem ersten und dem zweiten Substrat (1, 3), einer Metallschicht (2, 4) mit einer Dicke, die derart gesteuert ist, dass die Oberflächenrauigkeit jeder der aufgebrachten Metallschichten unter einer Rauigkeitsschwelle begrenzt wird, die eine Funktion des Metalls ist, aus dem die Metallschichten gebildet sind;
- Belüften der Metallschichten, die auf der Oberfläche des ersten und des zweiten Substrats aufgebracht sind;
- direktes Anhaften des ersten und des zweiten Substrats durch Inkontaktbringen der aufgebrachten metallischen Haftschichten, wobei die Oberflächenrauigkeit der in Kontakt gebrachten Schichten jene ist, die am Ende des Aufbringungsschritts erhalten wird.

2. Verfahren nach Anspruch 1, bei dem der Schritt des Anhaftens durchgeführt wird nach einer maximalen Expositionszeit an Luft der aufgebrachten Metallschichten im Anschluss an die Belüftung unterhalb von 30 Minuten, vorzugsweise unterhalb von 20 Minuten.

3. Verfahren nach einem der Ansprüche 1 und 2, bei dem der Schritt des Anhaftens bei einer Temperatur unterhalb von 50° C realisiert wird, vorzugsweise bei Umgebungstemperatur, beispielsweise zwischen 10° und 30° C.

4. Verfahren nach einem der Ansprüche 1 bis 3, bei dem der Schritt des Anhaftens bei Atmosphärendruck realisiert wird.

5. Verfahren nach einem der Ansprüche 1 bis 4, bei dem der Schritt des Anhaftens an Luft realisiert wird.

6. Verfahren nach einem der Ansprüche 1 bis 5, bei dem der Schritt des Anhaftens realisiert wird ohne Ausüben von Druck auf die Zusammenfügung des ersten und des zweiten Substrats, die aus dem Inkontaktbringen der metallischen Haftschichten resultiert.

7. Verfahren nach einem der Ansprüche 1 bis 6, umfassend vor der Aufbringung einer Metallschicht auf der Oberfläche des ersten Substrats einen Schritt des Bildens einer Oberflächenschicht auf dem ersten Substrat.

8. Verfahren nach Anspruch 7, bei dem die Oberflächenschicht eine Schicht ist, die eine Barriere bildet gegen die Diffusion des Materials der Metallschicht in das erste Substrat, beispielsweise eine Oberflächenschicht aus Titannitrid oder aus Tantalnitrid.

9. Verfahren nach Anspruch 7, bei dem die Oberflächenschicht eine Schicht aus einem Material ist, das aus den Dielektrika, den Nitriden oder den Metallen ausgewählt ist, deren Oberflächenrauigkeit kein direktes Anhaften des ersten und des zweiten Substrats erlaubt.

10. Verfahren nach einem der Ansprüche 1 bis 9, bei dem das erste und das zweite Substrat unterschiedliche thermische Ausdehnungskoeffizienten aufweisen.

11. Verfahren nach einem der Ansprüche 1 bis 10, bei dem die Metallschichten auf physikalischem Dampfphasenweg aufgebracht werden.

12. Verfahren nach einem der Ansprüche 1 bis 11, bei dem die Metallschichten Kupferschichten mit einer Dicke sind, die dazu gesteuert wird, ihre Oberflächenrauigkeit, wie gemessen mit einem Rasterkraftmikroskop, das eine Oberfläche von 1*1 µm² abtastet, unter 1,0 nm RMS zu begrenzen.

13. Verfahren nach einem der Ansprüche 1 bis 11, bei dem die Metallschichten Goldschichten mit einer Dicke sind, die dazu gesteuert wird, ihre Oberflächenrauigkeit, wie gemessen mit einem Rasterkraftmikroskop, das eine Oberfläche von 1*1 µm² abtastet, unter 1,2 nm RMS zu begrenzen.

14. Verfahren nach einem der Ansprüche 1 bis 13, umfassend vor dem Anhaften die Bildung einer Fragilisierungszone im Inneren des ersten Substrats durch Implantation von Atomsorten, und nach dem Anhaften das Entfernen eines Teils des ersten Substrats durch Trennung des ersten Substrats im Bereich der Fragilisierungszone.

## Claims

1. A method for assembling a first substrate (1) and a second substrate (3) via metal bonding layers (2, 4), comprising the steps of:
- depositing, onto the surface of each of the first and second substrates (1, 3), a metal layer (2, 4) with a controlled thickness to limit the surface roughness of each of the metal layers deposited below a roughness threshold which depends on the metal of which the metal layers are made;
- exposing the deposited metal layers onto the surface of the first and second substrates to the air;
- directly bonding the first and second substrates by contacting the deposited metal bonding layers, the surface roughness of the contacted layers being that obtained at the end of the depositing step.

2. The method according to claim 1, wherein the bonding step is implemented after a maximum time of air exposition of the deposited metal layers following said air exposition lower than 30 minutes, preferably lower than 20 minutes.

3. The method according to one of claims 1 and 2, wherein the bonding step is made at a temperature lower than 50 °C, preferably at room temperature, for example between 10 °C and 30 °C.

4. The method according to one of claims 1 to 3, wherein the bonding step is made at atmospheric pressure.

5. The method according to one of claims 1 to 4, wherein the bonding step is made in air.

6. The method according to one of claims 1 to 5, wherein the bonding step is made without applying pressure to the assembly of the first and second substrates resulting from contacting the metal bonding layers.

7. The method according to one of claims 1 to 6, comprising, before depositing a metal layer onto the surface of the first substrate, a step of forming a superficial layer on said first substrate.

8. The method according to claim 7, wherein the superficial layer is a barrier layer to the diffusion of the material of the metal layer into the first substrate, for example a superficial layer of titanium nitride or tantalum nitride.

9. The method according to claim 7, wherein the superficial layer is a layer of a material chosen from dielectrics, nitrides or metals the surface roughness of which does not enable the first and second substrates to be directly bonded.

10. The method according to one of claims 1 to 9, wherein the first and second substrates have different thermal expansion coefficients.

11. The method according to one of claims 1 to 10, wherein the metal layers are deposited by physical vapour deposition.

12. The method according to one of claims 1 to 11, wherein the metal layers are copper layers with a controlled thickness to limit their surface roughness, as measured with an atomic force microscope scanning an area of 1*1 µm², below 1.0 nm RMS.

13. The method according to one of claims 1 to 11, wherein the metal layers are gold layers with a controlled thickness to limit their surface roughness, as measured with an atomic force microscope scanning an area of 1*1 µm², below 1.2 nm RMS.

14. The method according to one of claims 1 to 13, comprising, prior bonding, forming, by implanting atomic species, an embrittling zone within the first substrate, and, following bonding, removing a portion of the first substrate by separating said first substrate at the embrittling zone.
